# EUROPEAN PATENT APPLICATION

(11) **EP 3 722 453 A1**
(43) Date of publication of application: **14.10.2020**
(21) Application number: 18885008.5
(22) Date of filing: 04.12.2018
(51) Int. Cl.: C23C 14/30, C23C 14/24, H01L 51/50, H05B 33/10, H05B 33/26

(54) **VAPOR DEPOSITION SOURCE, ELECTRON BEAM VACUUM DEPOSITION APPARATUS, AND MANUFACTURING METHOD FOR ELECTRONIC DEVICE**

(30) Priority: 08.12.2017 JP 2017236424
(71) Applicant: Sumitomo Chemical Co., Ltd., Tokyo 104-8260 (JP)
(72) Inventor: MORISHIMA Shinichi, Tsukuba-shi Ibaraki 300-3294 (JP); KISHIKAWA Eiji, Niihama-shi Ehime 792-0015 (JP); SHIMOGAWARA Masaya, Niihama-shi Ehime 792-0015 (JP)
(74) Representative: J A Kemp LLP
(86) International application number: PCT/JP2018/044585
(87) International publication number: WO 2019/111901

(57) **Abstract**

A vapor deposition source 14 according to one embodiment includes a crucible 20 that contains a vapor deposition material 6 to be heated and evaporated by irradiation with an electron beam EB, and a heater 22 disposed to surround an edge 20b of the crucible 20 closer to an opening 20a thereof. This configuration allows the edge of the crucible to be heated by the heater, and thus allows the vapor deposition material crawling up toward the edge to be evaporated. As a result, the vapor deposition material can be kept from flowing out and being deposited due to the vapor deposition material crawling up to the edge of the crucible.

## Description

### TECHNICAL FIELD

The present invention relates to a vapor deposition source, an electron beam vacuum deposition apparatus, and a method for manufacturing an electronic device.

### BACKGROUND ART

The vacuum deposition apparatus includes a vapor deposition source including a crucible, in which the vapor deposition material contained in the crucible is heated and evaporated, and then deposited on a film formation target substrate, thereby forming a film formation layer. In the case of forming a film formation layer in the vacuum deposition apparatus, a heated and melted vapor deposition material may travel along the inner surface of the crucible and crawl out from the edge of the crucible closer to the opening thereof. As a method for preventing this crawling out, a cold lip method of cooling an outlet (opening) of a crucible is known as employed in Patent Document 1.

### PRIOR ART DOCUMENT

### PATENT DOCUMENT

Patent Document 1: JP-A-2014-072005

### SUMMARY OF THE INVENTION

### PROBLEMS TO BE SOLVED BY THE INVENTION

For vacuum deposition methods with the use of electron beams, there is a tendency to use a crucible which is shallow to the bottom, and there is a need for continuous film formation at high speed in forming a film formation layer while transporting a substrate. In the film formation at high speed, the temperature of the vapor deposition material is likely to be increased, and thus, for example, even if a cold lip method is applied to a crucible for electron beam vacuum deposition as in Patent Document 1, the vapor deposition material may be insufficiently prevented from crawling out. When the vapor deposition material crawls up to the edge of the crucible closer to the opening, the vapor deposition material is cooled at the edge, and an evaporated material is thus deposited on the edge. Since a reflector that returns heat toward the crucible is typically disposed near the crucible, if the evaporated material is laterally deposited on the edge, there is a possibility that the crucible and the reflector may be connected by the evaporated material deposited. When the crucible and the reflector are connected by the vapor deposition material, the function of the reflector will be decreased, and the heat of the crucible will be taken away by the reflector, and the problem of decrease in vapor deposition rate will be caused. When the vapor deposition material crawls up to the edge of the crucible, then flows out from the edge, and for example, drips on the placement surface of the crucible in the vacuum deposition chamber, the vacuum deposition apparatus may be damaged.

An object of the present invention is to provide a vapor deposition source, an electron beam vacuum deposition apparatus, and a method for manufacturing an electronic device, which are capable of keeping the vapor deposition material from flowing out from the crucible and being deposited on the edge due to the vapor deposition material crawling up to the edge of the crucible closer to the opening thereof.

### MEANS FOR SOLVING THE PROBLEMS

A vapor deposition source according to one aspect of the present invention includes a crucible that contains a vapor deposition material to be heated and evaporated by irradiation with an electron beam, and a heater disposed to surround an edge of the crucible closer to an opening of the crucible.

This configuration allows the vapor deposition material crawling out toward the edge of the crucible closer to the opening thereof to be further heated and evaporated by the heater. Thus, the vapor deposition material is less likely to crawl up to the edge of the crucible. The vapor deposition material crawling up to the edge can be heated and evaporated in the same manner, and the vapor deposition material can be kept from flowing out from the edge and being deposited on the edge due to the crawling up.

The surface of the heater closer to the edge may at least partially have a flat surface.

The heater also surrounds an outer surface of the crucible, and the heater is separated from the edge and the outer surface such that the vapor deposition material scattered from the crucible toward the heater is scattered toward the opening as viewed from the bottom of the crucible in the axial direction of the crucible. Thus, for example, in the case where the crucible is disposed on the bottom of the vacuum deposition chamber, the vapor deposition material can be kept from being deposited on the bottom. In this regard, the outer surface of the crucible refers to the surface of the crucible on the side opposite to the side of the crucible for containing the vapor deposition material.

The heater may have a first heating region located lateral to the edge, and a second heating region located closer to the bottom in the axial direction of the crucible than the first heating region, the first heating region may be disposed such that the distance between one region of the first heating region closer to the second heating region and the axis of the crucible is equal to a distance between the other region of the first heating region and the axis of the crucible, or shorter than the distance between the other region of the first heating region and the axis of the crucible, and the second heating region may be disposed such that the distance between one region of the second heating region closer to the first heating region and the outer surface of the crucible is equal to the distance between the other region of the second heating region and the outer surface of the crucible, or longer than the distance between the other region of the second heating region and the outer surface of the crucible. This configuration allows the vicinity of the edge to be heated in the first heating region. Furthermore, by providing the second heating region, even if the vapor deposition material evaporated near the edge of the crucible is scattered toward the bottom in the axial direction of the crucible, the material can be scattered again toward the opening as viewed from the bottom in the axial direction of the crucible in the second heating region.

The edge of the heater farthest from the bottom of the crucible in the axial direction of the crucible may be located farther from the bottom than the edge of the crucible in the axial direction of the crucible. Thus, in a direction orthogonal to the axis of the crucible, the vapor deposition material can be prevented from scattering outside the heater.

The vapor deposition material may be aluminum. The material of the crucible may include at least one of a pyrolytic boron nitride, a pyrolytic graphite, a pyrolytic silicon carbide, a pyrolytic silicon nitride, a pyrolytic aluminum nitride, an aluminum oxide, a boron nitride, an aluminum nitride, a silicon carbide, and a graphite. In the case where the vapor deposition material is aluminum, the vapor deposition material is likely to crawl up when the material of the crucible includes the exemplary material, and the configuration of the vapor deposition source is thus effective.

Another aspect of the present invention also relates to an electron beam vacuum deposition apparatus including the above-mentioned vapor deposition source.

A method for manufacturing an electronic device according to still another aspect of the present invention is a method for manufacturing an electronic device manufactured by sequentially forming a first electrode layer, a device function unit, and a second electrode layer on a support substrate, and at least one of a step of forming the first electrode layer and a step of forming the second electrode layer includes a film formation layer forming step of forming a film formation layer by a vacuum deposition method with use of the above vapor deposition source method.

The vapor deposition source mentioned above is suitable for, for example, continuous film formation at high speed, because the vapor deposition material can be kept from crawling up even if the temperature of the vapor deposition material is increased. Accordingly, the use of the vapor deposition source allows the time for the film formation layer forming step to be reduced, and as a result, allows the productivity of the electronic device to be improved.

The support substrate may be long and flexible, and in the film formation layer forming step, the film formation layer may be formed while continuously transporting the support substrate. In this case, the productivity of the electronic device can be improved.

### EFFECT OF THE INVENTION

According to the present invention, a vapor deposition source, an electron beam vacuum deposition apparatus, and a method for manufacturing an electronic device can be provided, which are capable of keeping the vapor deposition material from flowing out and being deposited due to the vapor deposition material crawling up to the edge of the crucible closer to the opening thereof.

### BRIEF DESCRIPTION OF THE DRAWINGS

Fig. 1 is a schematic diagram of an electron beam vacuum deposition apparatus including a vapor deposition source according to one embodiment.
Fig. 2 is an end view schematically illustrating a configuration of a vapor deposition source according to one embodiment.
Fig. 3 is a diagram in the case of viewing the vapor deposition source shown in Fig. 2 from the opening side.
Fig. 4 is a diagram showing an example of a state in which a vapor deposition material contained in the vapor deposition source shown in Fig. 2 is heated by an electron beam.
Fig. 5 is a schematic diagram of an organic EL device manufactured by a method for manufacturing an electronic device according to one embodiment.

### MODE FOR CARRYING OUT THE INVENTION

Hereinafter, embodiments of the present invention will be described with reference to the drawings. The same elements are denoted by the same reference numerals, and repeated descriptions will be omitted. The dimensional ratios in the drawings do not always coincide with the ratios described.

### (First Embodiment)

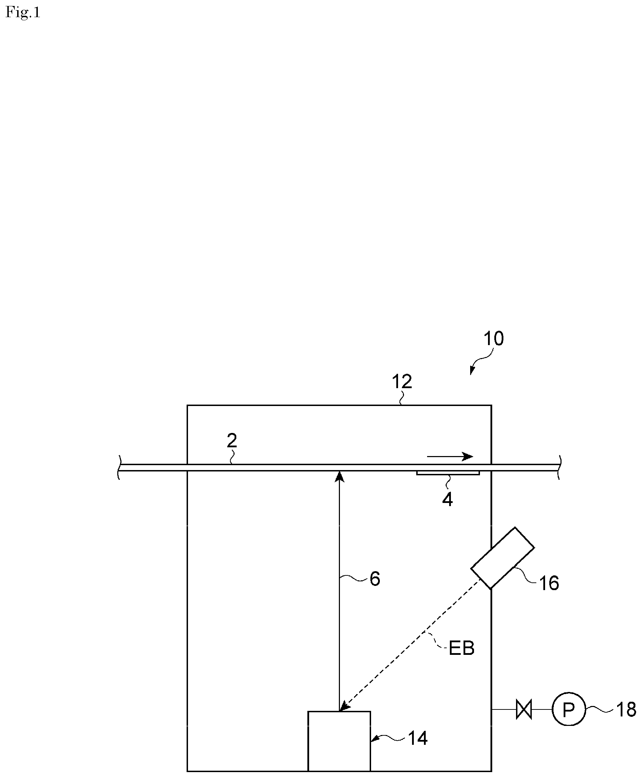

Fig. 1 is a schematic diagram of an electron beam vacuum deposition apparatus including a vapor deposition source according to one mode. The vacuum deposition apparatus 10 shown in Fig. 1 includes a vacuum deposition chamber 12, a vapor deposition source 14, and an electron gun 16. The vacuum deposition apparatus 10 is an electron beam vacuum deposition apparatus for vacuum deposition with the use of an electron beam EB. Fig. 1 also illustrates, for the sake of explanation, a film formation target substrate 2 which is a belt-like substrate on which a film formation layer 4 is formed by the vacuum deposition apparatus 10. In the following description (including the description of the second embodiment described later), the film formation target substrate 2 will be simply referred to as a "substrate 2".

The vacuum deposition chamber 12 is configured such that the inside of the vacuum deposition chamber 12 is adjusted to a predetermined vacuum state by a vacuum pump 18, and configured such that the substrate 2 can be continuously transported. The vapor deposition source 14 containing a vapor deposition material 6 that is a material for the film formation layer 4 to be formed is disposed in the vacuum deposition chamber 12 such that the vapor deposition material 6 heated and evaporated by the electron beam EB from the electron gun 16 is deposited on the substrate 2. In Fig. 1, the vapor deposition source 14 is schematically shown by a block. The vapor deposition source 14 will be described in detail later. The electron gun 16 outputs the electron beam EB for heating the vapor deposition material 6 in the vapor deposition source 14. The electron beam EB may be, for example, deflected by a deflection device or the like and applied to irradiate the vapor deposition material 6 housed in the vapor deposition source 14. The configuration of the electron gun 16 is not limited as long as the vapor deposition material 6 can be heated by the electron beam EB, and is also not limited to the arrangement shown in Fig. 1.

Fig. 1 shows only main constituent elements of the vacuum deposition apparatus 10. The vacuum deposition apparatus 10 can include a known configuration such as a material supply unit that supplies the vapor deposition material 6 into the vapor deposition source 14, for example.

An example of a film formation layer forming step that uses the vacuum deposition apparatus 10 will be described. First, the inside of the vacuum deposition chamber 12 is brought into a predetermined vacuum state by the vacuum pump 18. Thereafter, the substrate 2 is passed through the vacuum deposition chamber 12 while continuously transporting the substrate 2. While the substrate 2 is passing through the vacuum deposition chamber 12, the vapor deposition material 6 in the vapor deposition source 14 is irradiated with the electron beam EB from the electron gun 16 attached to the vacuum deposition chamber 12 to heat and evaporate the vapor deposition material 6. The vapor deposition material 6 heated and evaporated is deposited on the substrate 2 to form the film formation layer 4. In the formation of the film formation layer 4 with the use of the vacuum deposition apparatus 10, the film formation layer 4 can be selectively formed in a predetermined region of the substrate 2 with the use of a mask.

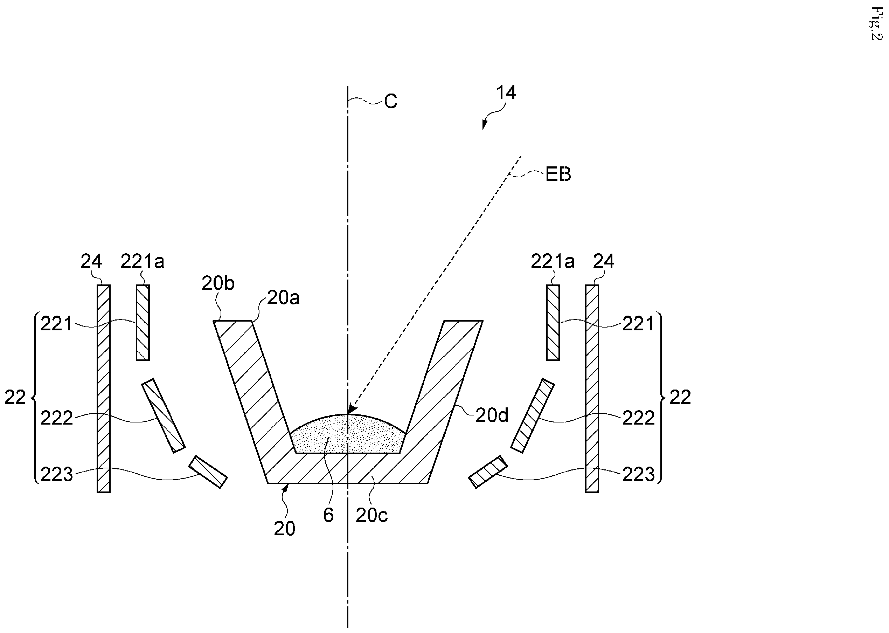

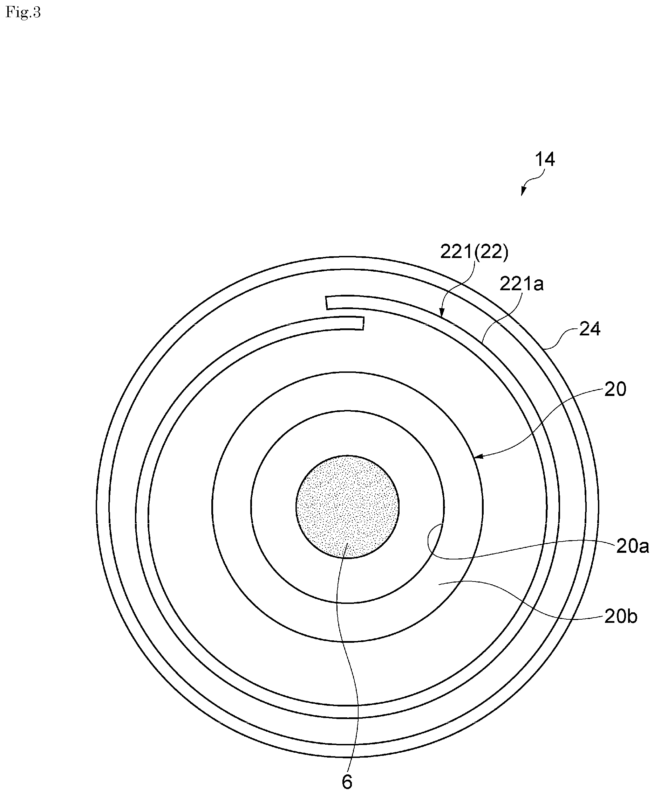

Next, the vapor deposition source 14 will be described with reference to Figs 2 and 3. Fig. 2 is an end view schematically illustrating a configuration of a vapor deposition source for an electron beam vacuum deposition apparatus according to one embodiment. Fig. 3 is a diagram in the case of viewing the vapor deposition source shown in Fig. 2 from the opening side. As shown in Figs. 2 and 3, the vapor deposition source 14 includes a hearth liner (crucible) 20 and a heater 22. In the description of the vapor deposition source 14, for the sake of explanation, as shown in Fig. 2, in the direction of the axis C of the hearth liner (crucible) 20, the side closer to an opening 20a (or the side closer to the substrate 2) is considered as the upper side, and the side closer to a bottom 20c is considered as the lower side.

The hearth liner 20 is a container that contains vapor deposition material 6. The vapor deposition material 6 is heated and then evaporated (evaporated by heating) by irradiation with the electron beam EB. The vapor deposition material 6 is a material for a layer (film formation layer) formed with the use of the vapor deposition source 14. Examples of the vapor deposition material 6 include metals that evaporate in a molten state, such as aluminum (Al), gallium (Ga), indium (In), zinc (Zn), tin (Sn), silver (Ag), and gold (Au). The material of the hearth liner 20 includes at least one of, for example, a pyrolytic boron nitride (PBN), a pyrolytic graphite (PG), a pyrolytic silicon carbide (PSiC), a pyrolytic silicon nitride (PSi₃N₄), a pyrolytic aluminum nitride (PAIN), an aluminum oxide (Al₂O₃), a boron nitride (BN), an aluminum nitride (AlN), a silicon carbide (SiC), and graphite (C).

The hearth liner 20 has a cylindrical shape with a bottom. In the case where the hearth liner 20 is viewed from above, the shape of the opening 20a of the hearth liner 20 may be circular as shown in Fig. 3 or may be quadrangular (square or rectangular). The opening 20a of the hearth liner 20 typically has a longer maximum width than the height of the hearth liner 20, and has a dish shape or a flattened shape. The maximum width of the opening 20a may be the diameter thereof in the case where the shape of the opening 20a is circular, and may be the length of a diagonal line in the case where the shape is quadrangular. The inside diameter of the hearth liner 20 may be smaller on the side closer to the bottom 20c than on the side closer to the opening 20a.

The heater 22 is spaced apart from the hearth liner 20 so as to surround an edge 20b of the hearth liner 20 on the side closer to the opening 20a. The heater 22 has a first heating unit (first heating region) 221. As shown in Fig. 2, the heater 22 may have a second heating unit (second heating region) 222, and may further have a third heating unit 223. Hereinafter, unless otherwise noted, an embodiment will be described in which the heater 22 includes the second heating unit 222 and the third heating unit 223 in addition to the first heating unit 221.

As shown in Figs. 2 and 3, the first heating unit 221 is spaced apart from the edge 20b and an outer surface 20d lateral to the edge 20b so as to surround the edge 20b on the side closer to the opening 20a of the hearth liner 20. The first heating unit 221, which is a planar (or plate-shaped) heating element, generates heat when a current supplied from a power supply (not shown) flows. In the present embodiment, the first heating unit 221 is the heating element mentioned above, but a power supply connected to the heating element may be also a constituent element of the first heating unit 221.

Examples of the material for the first heating unit 221 include materials that are used for resistance heating elements. Examples of the material for the first heating unit 221 include metals such as molybdenum (Mo), tungsten (W), tantalum (Ta), niobium (Nb), chromium (Cr), and platinum (Pt), alloys containing the foregoing metals, carbon materials (for example, carbon (C), carbon fibers), silicon carbide (SiC), ceramics (for example, molybdenum disilicide (MoSi₂), silicon nitride (Si₃N₄), alumina (Al₂O₃)). As shown in Fig. 3, one end of the first heating unit 221 and the other end thereof are separated in the circumferential direction of the edge 20b of the hearth liner 20. The vicinity of the one end of the first heating unit 221 and the vicinity of the other end preferably overlap with each other in a direction orthogonal to the axis C. The first heating unit 221 may be disposed such that the distance between one region of the first heating unit 221 closer to the second heating unit 222 (a lower region of the first heating unit 221) and the axis C of the hearth liner 20 is equal to the distance between the other region of the first heating unit 221 (the upper region of the first heating unit 221) and the axis C of the hearth liner 20, or shorter than the distance between the other region of the first heating unit 221 and the axis C of the hearth liner 20. In other words, the first heating unit 221 may be disposed such that the distance from the axis C of the hearth liner 20 is constant in the direction of the axis C, or such that the distance from the axis C is increased from the lower side of the first heating unit 221 toward the upper side thereof. In one embodiment, the first heating unit 221 may be disposed such that an upper edge 221a of the first heating unit 221 (on the farthest side from the bottom 20c of the hearth liner 20 in the direction of the axis C) is located above the edge 20b of the hearth liner 20 (on the farther side from the bottom 20c than the edge 20b, on the side closer to the substrate 2). The distance between the first heating unit 221 and the axis C of the hearth liner 20 refers to the length between the first heating unit 221 and the axis C of the hearth liner 20 in a direction orthogonal to the axis C.

The second heating unit 222 has the same configuration as that of the first heating unit 221, except that the second heating unit 222 is disposed below the first heating unit 221 (on the side closer to the bottom 20c of the hearth liner 20 in the direction of the axis C) so as to surround the outer surface 20d of the hearth liner 20. The power supply connected to the second heating unit 222 may be common to the power supply connected to the first heating unit 221, or may be another power supply. In Fig. 3, the illustration of the second heating unit 222 is omitted from the viewpoint of ease of viewing the drawing. The second heating unit 222 may be disposed such that the distance between one region of the second heating unit 222 closer to the first heating unit 221 (an upper region of the second heating unit 222) and the outer surface 20d of the hearth liner 20 is equal to the distance between the other region of the second heating unit 222 (the lower region of the second heating unit 222) and the outer surface 20d of the hearth liner 20, or longer than the distance between the other region of the second heating unit 222 and the outer surface 20d of the hearth liner 20. In other words, the second heating unit 222 may be disposed parallel to the outer surface 20d of the hearth liner 20, or, on the upper side of the second heating unit 222, disposed to be inclined outward from the state parallel to the outer surface 20d. The distance between the second heating unit 222 and the outer surface 20d of the hearth liner 20 refers to the length between the second heating unit 222 and the outer surface 20d in a direction orthogonal to the axis C.

The third heating unit 223 has the same configuration as that of the first heating unit 221, except that the second heating unit 222 is disposed below the second heating unit 222 (on the side closer to the bottom 20c of the hearth liner 20 in the direction of the axis C) so as to surround the outer surface 20d of the hearth liner 20. The power supply connected to the third heating unit 223 may be common to the power supply connected to the first heating unit 221, or may be another power supply. In Fig. 3, the illustration of the third heating unit 223 is omitted from the viewpoint of ease of viewing the drawing. The third heating unit 223 can be disposed in the same manner as the second heating unit 222. More specifically, the third heating unit 223 may be disposed parallel to the outer surface 20d of the hearth liner 20, or, on the upper side of the second heating unit 222, disposed to be inclined outward from the state parallel to the outer surface 20d.

As shown in Fig. 2, in the case where the outer surface 20d is inclined outward with respect to the axis C, such that the upper side of the hearth liner 20 (on the side closer to the opening 20a) is inclined outward, the inner surfaces of the second heating unit 222 and third heating unit 223 face upward (toward the substrate 2). Thus, also in the case where the second heating unit 222 and the third heating unit 223 are inclined further outward from the state parallel to the outer surface 20d of the hearth liner 20, the inner surfaces of the second heating unit 222 and third heating unit 223 similarly face upward.

The vapor deposition source 14 may include a reflector 24 outside the heater 22. The reflector 24 can be a cylindrical body disposed so as to surround the hearth liner 20 and the heater 22. The reflector 24 is a heat reflecting member for reflecting the heat generated by heating the vapor deposition material 6 and the heat generated by the heater 22 toward the hearth liner 20. Examples of the material for the reflector 24 may be the same as the material for the first heating unit 221.

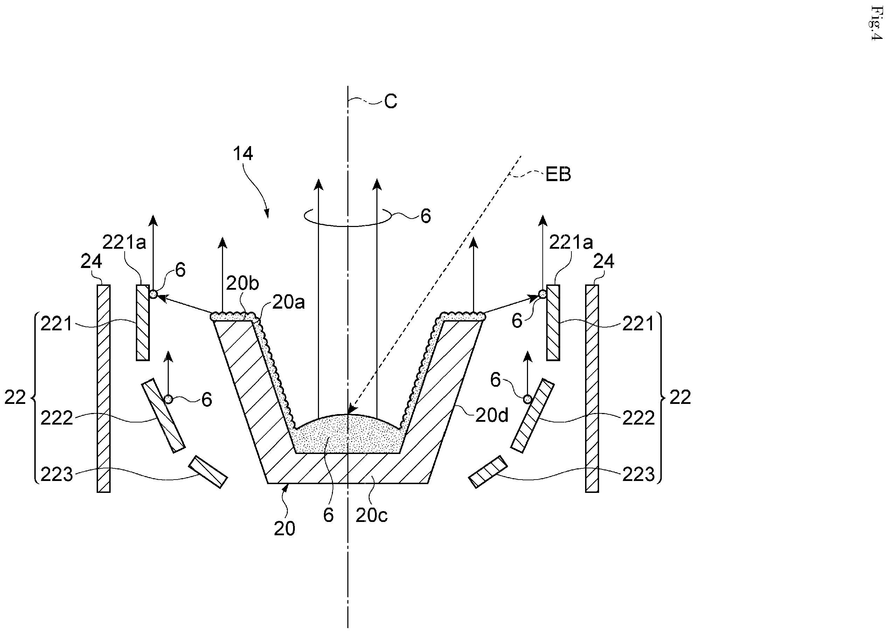

As shown in Fig. 4, when the vapor deposition material 6 contained in the hearth liner 20 is irradiated with the electron beam EB to heat and then evaporate the vapor deposition material 6 in order to form the film formation layer 4 (see Fig. 1), the vapor deposition material 6 may be partially melted by the heating, thereby crawling up along the inner surface of the hearth liner 20 toward the edge 20b. In order to eliminate the problems associated with such crawling up, the vapor deposition source 14 includes the heater 22.

In order to explain the function effect of including the heater 22, first, in the case of including no heater 22, the problem will be explained in the case where the vapor deposition material 6 crawls up along the inner surface of the hearth liner toward the edge closer to the opening. In this case, when the vapor deposition material crawls to the edge closer to the opening of the hearth liner, the vapor deposition material is cooled and deposited near the edge. If the vapor deposition source includes no heater 22, there is a tendency to dispose a reflector near the hearth liner in order to return heat toward the hearth liner. Thus, when the vapor deposition material is deposited on the edge and further protruded in a lateral direction, there is a possibility that the reflector and the hearth liner may be connected by the vapor deposition material 6 deposited in the lateral direction from the edge. When the reflector and the hearth liner are connected by the vapor deposition material 6, the function of the reflector will be decreased, and the heat of the hearth liner will be taken by the reflector, and the vapor deposition rate will be then decreased. When the vapor deposition material 6 is deposited on the edge, for example, in the case of continuous film formation at high speed, the opening may be blocked by the vapor deposition material 6 deposited on the edge of the hearth liner closer to the opening. Furthermore, when the vapor deposition material 6 crawling up to the edge is deposited by dripping on the bottom of the vacuum deposition chamber where the hearth liner is disposed (the placement surface of the hearth liner), the vacuum deposition apparatus may be damaged.

On the other hand, the vapor deposition source 14 of the present embodiment includes the heater 22. The heater 22 has the first heating unit 221 surrounding the edge 20b, and thus can positively heat the vicinity of the edge 20b with radiant heat from the first heating unit 221, in addition to heating by the electron beam EB. As a result, as shown in Fig. 4, the vapor deposition material 6 crawling up toward the edge 20b can be further heated and evaporated, thereby keeping the vapor deposition material 6 from crawling up to the edge 20b and flowing out to the outer surface 20d or the like from the edge 20b. Fig. 4 shows the vapor deposition material 6 flowing to the edge 20b, for the explanation of the function effect created by the heater 22. Furthermore, the heater 22 heats the vicinity of the edge 20b, thereby also making it possible to keep the vapor deposition material 6 from being deposited on the edge 20b. Furthermore, since the vapor deposition material 6 crawling up is heated and evaporated, the opening 20a is not blocked by the vapor deposition material 6, for example, even if continuous film formation at high speed is carried out. Moreover, since the vapor deposition material 6 crawling up can be kept from flowing out from the edge 20b, no vapor deposition material 6 drips on the bottom of the vacuum deposition chamber 12. Thus, the vacuum deposition apparatus 10 including the vapor deposition source 14 can be kept from being damaged. Since no vapor deposition material 6 drips on the bottom of the vacuum deposition chamber 12, maintenance of the vacuum deposition chamber 12 is easy. Furthermore, since the vapor deposition material 6 evaporated on heating by the heater 22 also contributes to the formation of the film formation layer 4, the vapor deposition material 6 can be efficiently used.

As mentioned above, the heater 22 is provided for the hearth liner 20, thereby eliminating the problem associated with the vapor deposition material 6 crawling up to the edge 20b. Thus, for example, it is not necessary to make the shape of the hearth liner 20 complex in order to prevent the crawling. Since there is no need to make the shape of the hearth liner 20 complex, the hearth liner 20 is less likely to be broken by stress even at high temperatures.

There is a tendency to use a hearth liner 20 which is relatively shallow to the bottom for a crucible in a vacuum deposition method with the use of an electron beam EB. In such a hearth liner 20, the vapor deposition material 6 is likely to crawl up, and thus, the vapor deposition source 14 is effective which is capable of heating the edge 20b with the heater 22 and then further evaporating the vapor deposition material 6 near the edge 20b.

In continuous film formation at high speed onto the substrate 2, the temperature of the vapor deposition material 6 tends to be increased, and the vapor deposition material 6 is likely to crawl up to the edge 20b. Also in this case, in the vapor deposition source 14, the edge 20b can be heated by the heater 22, thereby further evaporating the vapor deposition material 6 near the edge 20b, and the problem with crawling up can be thus controlled. Accordingly, in the vacuum deposition apparatus 10 including the vapor deposition source 14, the film formation layer 4 can be formed at high speed on the substrate 2. As a result, as described with reference to Fig. 1, the vacuum deposition apparatus 10 is capable of forming the film formation layer 4 while continuously transporting the substrate 2, and reducing the time for the step of forming the film formation layer 4 (film formation layer forming step).

In the embodiment in which the heater 22 has the second heating unit 222 in addition to the first heating unit 221, the radiant heat from the second heating unit 222 can heat the outer surface 20d of the hearth liner 20, thus heating and evaporating the vapor deposition material 6 crawling up toward the edge 20b. Accordingly, it is possible to keep the vapor deposition material 6 from crawling up to the edge 20b. In the embodiment including the third heating unit 223, for the same reason, it is possible to further keep the vapor deposition material 6 from crawling up to the edge 20b.

Furthermore, in the embodiment in which the heater 22 has the second heating unit 222, the vapor deposition material 6 evaporated near an edge 22b and scattered downward (toward the bottom 20c in the direction of the axis C) by heating with the first heating unit 221 is further evaporated upward (toward the opening 20a in the direction of the axis C, toward the substrate 2). Thus, the vapor deposition material 6 can be also kept from being deposited on the bottom of the vacuum deposition chamber 12 where the hearth liner 20 is disposed. In the case where the third heating unit 223 is further provided, the vapor deposition material 6 can also be further kept from being deposited on the bottom of the vacuum deposition chamber 12.

As long as the heater 22 is spaced apart from the hearth liner 20, and configured and disposed to allow the vapor deposition material 6 scattered toward the heater 22 to be scattered upward through the space between the heater 22 and the hearth liner 20 (toward the opening 20a in the direction of the axis C, toward the substrate 2), the vapor deposition material 6 can be kept from being deposited on the bottom of the vacuum deposition chamber 12, and the vapor deposition material 6 can be effectively used.

For example, in the embodiment in which the first heating unit 221 is disposed such that the distance between the axis C of the hearth liner 20 and the first heating unit 221 is increased from the lower side toward the upper side, the inner surface of the first heating unit 221 faces upward, thus making the vapor deposition material 6 more likely to be scattered upward. The same applies to the case where the second heating unit 222 and the third heating unit 223 are arranged such that the inner surfaces thereof face upward. In particular, to the second heating unit 222 and the third heating unit 223, the vapor deposition material 6 is scattered downward from the edge 20b, and the configuration of the second heating unit 222 and the third heating unit 223 arranged such that the inner surfaces thereof face upward is thus effective. For example, when the second heating unit 222 and the third heating unit 223 are inclined outward from the state parallel to the outer surface 20d of the hearth liner 20 on the upper sides of the second heating unit 222 and third heating unit, the vapor deposition material 6 evaporated by the heating the second heating unit 222 and the third heating unit 223 is likely to be scattered toward the substrate 2 without colliding with the outer surface 20d of the hearth liner 20.

In the embodiment in which the height of the edge 221a of the first heating unit 221 with respect to the bottom 20c of the hearth liner 20 is larger than that of the edge 20b of the hearth liner 20 (i.e., the edge 221a is farther from the bottom 20c than the edge 20b), even if the vapor deposition material 6 heated and evaporated near the edge 20b scatters laterally, the vapor deposition material 6 will be blocked by the first heating unit 221, and thus less likely to scatter outward from the first heating unit 221 in a direction orthogonal to the axis C. Accordingly, the vapor deposition material 6 can be kept from being deposited on the side wall surface of the vacuum deposition chamber 12 (the side wall surface near the vapor deposition source 14).

In the case where the material of the hearth liner 20 has high wettability to the vapor deposition material 6, the vapor deposition material 6 is considered likely to crawl up. Accordingly, in the case where the material of the hearth liner 20 has high wettability to the vapor deposition material 6 used, the configuration of the vapor deposition source 14 is effective. For example, in the case where the vapor deposition material 6 is aluminum (Al), whereas the material of the hearth liner 20 partially includes at least one of a pyrolytic boron nitride (PBN), a pyrolytic graphite (PG), a pyrolytic silicon carbide (PSiC), a pyrolytic silicon nitride (PSi₃N₄), a pyrolytic aluminum nitride (PAIN), an aluminum oxide (Al₂O₃), a boron nitride (BN), an aluminum nitride (AlN), a silicon carbide (SiC), and graphite (C), the configuration is effective, and effective, in particular, in the case of including PBN, BN, or SiC. Although the explanation is given herein from the viewpoint of wettability, the configuration of the vapor deposition source 14 is also effective, for example, in the case where the hearth liner 20 is configured with such a material that causes the vapor deposition material 6 to bring about a capillary phenomenon with respect to the hearth liner 20.

### (Second Embodiment)

As a second embodiment, a method for manufacturing an organic EL device (electronic device) 26 with the use of the vapor deposition source 14 described in the first embodiment will be described. Unless otherwise noted, the bottom emission-type organic EL device 26 will be described below, but the organic EL device 26 may be a top emission-type organic EL device.

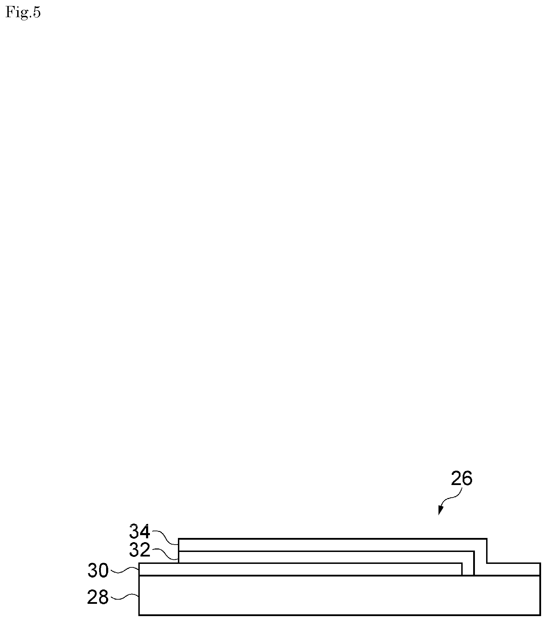

Fig. 5 is a schematic diagram for explaining the configuration of the organic EL device 26 to be manufactured. The organic EL device 26 includes a support substrate 28, an anode layer (first electrode layer) 30, an organic EL unit (device function unit) 32, and a cathode layer (second electrode layer) 34.

### [Support Substrate]

The support substrate 28 has the property of transmitting visible light (light of 400 nm to 800 nm in wavelength). The thickness of the support substrate 28 is, for example, 30 µm to 500 µm, and can have a film shape. In the case where the support substrate 28 is a resin, for example, the thickness is preferably 45 µm or more from the viewpoint of preventing the substrate from being distorted, wrinkled, and stretched in continuous transport in accordance with a roll-to-roll system, and preferably 125 µm or less from the viewpoint of flexibility.

The support substrate 28 with flexibility is, for example, a plastic film. Examples of the material of the support substrate 28 include polyester resins such as polyether sulfone (PES), polyethylene terephthalate (PET), and polyethylene naphthalate (PEN); polyolefin resin such as polyethylene (PE), polypropylene (PP), cyclic polyolefins; polyamide resins; polycarbonate resins; polystyrene resins; polyvinyl alcohol resins; saponified ethylene-vinyl acetate copolymers; polyacrylonitrile resins; acetal resins; polyimide resins; and epoxy resins.

The material of the support substrate 28 is, among the above-mentioned resins, preferably a polyester resin or a polyolefin resin, more preferably polyethylene terephthalate or polyethylene naphthalate, because the resin is high in heat resistance, low in linear expansion coefficient, and low in manufacturing cost. One of these resins may be used alone, or two or more thereof may be used in combination.

The support substrate 28 may be a thin film glass. In the case where the support substrate 28 is a thin film glass, the thickness thereof is preferably 30 µm or more from the viewpoint of strength, and preferably 100 µm or less from the viewpoint of flexibility.

On the support substrate 28, a barrier layer that blocks gas, moisture, and the like (in particular, a barrier layer that blocks moisture) may be disposed.

### [Anode Layer]

The anode layer 30 is provided on the support substrate 28. For the anode layer 30, an electrode layer that has a light-transmitting property is used. As the electrode that has a light-transmitting property, thin films including a metal oxide, a metal sulfide, a metal, and the like which are high in electric conductivity can be used, and thin films which are high in light transmittance are preferably used. For example, a thin film is used which is made of an indium oxide, a zinc oxide, a tin oxide, an indium tin oxide (abbreviated as an ITO), an indium zinc oxide (abbreviated as an IZO), gold, platinum, silver, copper, or the like, and among these films, the thin film including an ITO, an IZO, or a tin oxide is preferably used. As the anode layer 30, transparent conductive films of organic substances such as polyaniline and derivatives thereof and polythiophene and derivatives thereof may be used. The anode layer 30 may have a network structure formed of a conductor (for example, a metal).

The anode layer 30 may have a multilayer structure. The thickness of the anode layer 30 can be determined in consideration of light transmittance, electric conductivity, and the like. The thickness of the anode layer 30 is typically 10 nm to 10 µm, preferably 20 nm to 1 µm, more preferably 50 nm to 200 nm.

The anode layer 30 can be formed by a dry film formation method, a plating method, a coating method, or the like. Examples of the dry film formation method include a vacuum deposition method, a sputtering method, an ion plating method, and a CVD method. In the case of forming the anode layer 30 by a vacuum evaporation method, the anode layer 30 can be formed by an electron beam vacuum deposition method with the use of the vapor deposition source 14 described in the first embodiment, for example. In the case where the anode layer 30 has a multilayer structure, the same applies in the case of forming at least one of the film formation layers by a vacuum deposition method. Examples of the coating method include an inkjet printing method, a slit coating method, a micro-gravure coating method, a gravure coating method, a bar coating method, a roll coating method, a wire bar coating method, a spray coating method, a screen printing method, a flexographic printing method, an offset printing method, and a nozzle printing method.

### [Organic EL Unit]

The organic EL unit 32 serves as a functional unit that contributes to light emissions of the organic EL device 26, such as charge transfer and charge recombination, depending on the voltage applied to the anode layer 30 and the cathode layer 34, and has a light-emitting layer.

The light-emitting layer is a functional layer that has the function of emitting light (including visible light). The light-emitting layer is typically composed of an organic substance that mainly produces at least one of fluorescence and phosphorescence, or of this organic substance and a dopant material that assists the organic substance. Thus, the light-emitting layer is an organic layer. The dopant material is added, for example, in order to improve the luminescent efficiency or change the luminescence wavelength. The organic substance may be a low-molecular compound or a high-molecular compound. The thickness of the light-emitting layer is, for example, 2 nm to 200 nm.

Examples of the organic substance mainly as a luminescent material that produces at least one of fluorescence and phosphorescence include the following dye-based materials, metal complex-based materials, and polymeric materials.

### (Dye-based Material)

Examples of the dye-based materials include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, and thiophene ring compounds, pyridine ring compounds, perinone derivatives, perylene derivatives, oligothiophene derivatives, oxadiazole dimers, pyrazoline dimers, quinacridone derivatives, coumarin derivatives.

### (Metal Complex-based Material)

Examples of the metal complex-based materials include metal complexes having rare-earth metals such as Tb, Eu, and Dy, or Al, Zn, Be, Ir, Pt, or the like as a central metal, and having an oxadiazole, thiadiazole, phenylpyridine, phenylbenzmidazole, or quinoline structure or the like as a ligand, for example, a metal complex with luminescence from a triplet excited state, such as an iridium complex and a platinum complex, an aluminum quinolinol complex, a benzoquinolinol beryllium complex, a benzooxazolyl zinc complex, a benzothiazole zinc complex, an azomethyl zinc complex, a porphyrin zinc complex, and a phenanthroline europium complex.

### (Polymeric Material)

Examples of the polymeric materials include polyparaphenylene vinylene derivatives, polythiophene derivatives, polyparaphenylene derivatives, polysilane derivatives, polyacetylene derivatives, polyfluorene derivatives, polyvinyl carbazole derivatives, and the above-mentioned dye-based materials and metal complex-based luminescent materials polymerized.

### (Dopant Material)

Examples of the dopant material include perylene derivatives, coumarin derivatives, rubrene derivatives, quinacridone derivatives, squarylium derivatives, porphyrin derivatives, styryl-based dyes, tetracene derivatives, pyrazolone derivatives, decacyclene, and phenoxazone.

The light-emitting layer can be formed, for example, by a coating method. Examples of the coating method are the same as those in the case of the anode layer 30.

The organic EL unit 32 may have various functional layers, besides the light-emitting layer. Examples of the functional layer disposed between the anode layer 30 and the light-emitting layer include a hole injection layer and a hole transport layer. Examples of the functional layer disposed between the cathode layer 34 and the light-emitting layer include an electron injection layer and an electron transport layer.

Examples of the layer configuration of the organic EL unit 32 are shown below. In the following examples of the layer configuration, the anode layer and the cathode layer are also listed in parentheses in order to show the positional relations among the anode layer 30, the cathode layer 34, and various functional layers.
(a) (anode layer)/light-emitting layer/(cathode layer)
(b) (anode layer)/hole injection layer/light-emitting layer/(cathode layer)
(c) (anode layer)/hole injection layer/light-emitting layer/electron injection layer/(cathode layer)
(d) (anode layer)/hole injection layer/light-emitting layer/electron transport layer/electron injection layer/(cathode layer)
(e) (anode layer)/hole injection layer/hole transport layer/light-emitting layer/(cathode layer)
(f) (anode layer)/hole injection layer/hole transport layer/light-emitting layer/electron injection layer/(cathode layer)
(g) (anode layer)/hole injection layer/hole transport layer/light-emitting layer/electron transport layer/electron injection layer/(cathode layer)
(h) (anode layer)/light-emitting layer/electron injection layer/(cathode layer)
(i) (anode layer)/light-emitting layer/electron transport layer/electron injection layer/(cathode layer)

The symbol "/" means that the layers on both sides of the symbol "/" are joined.

Known materials may be used as materials for the functional layers (for example, a hole injection layer, a hole transport layer, an electron injection layer, an electron transport layer) of the organic EL unit 32, other than the light-emitting layer. The thicknesses of the functional layers of the organic EL unit 32 have optimum values that differs depending on the materials used. The thicknesses of the functional layers of the organic EL unit 32 are set in consideration of electric conductivity, durability, and the like. The functional layers of the organic EL unit 32 other than the light-emitting layer can be formed in the same way as the light-emitting layer. The electron injection layer may be a part of the cathode layer 34.

### [Cathode Layer]

The cathode layer 34 is provided on the organic EL unit 32. The cathode layer 34 can be provided so as to be brought into contact with the support substrate 28 on the side of the anode layer 30 opposite to the part thereof exposed from the organic EL unit 32. The cathode layer 34 may have a laminated structure of two or more layers laminated.

In order to reflect the light from the organic EL unit 32 at the cathode layer 34 to deliver the reflected light toward the anode layer 30, the material of the cathode layer 34 is preferably a material that is high in reflectance with respect to the light from the organic EL unit 32. As a material of the cathode layer 34, for example, alkali metals, alkaline-earth metals, transition metals, Group 13 metals of the periodic table, and the like may be used. Specifically, as the material of the cathode layer 34, for example, a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the metals, an alloy of one or more of the metals and one or more of gold, silver, platinum, copper, manganese, titanium, cobalt, nickel, tungsten, and tin, graphite or a graphite intercalation compound, or the like is used. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

As the cathode layer 34, for example, a transparent conductive electrode including a conductive metal oxide, a conductive organic substance, or the like may be used. Specific examples of the conductive metal oxide include an indium oxide, a zinc oxide, a tin oxide, an ITO, and an IZO, and examples of the conductive organic substance include polyaniline and derivatives thereof and polythiophene and derivatives thereof.

The thickness of the cathode layer 34 is set in consideration of electric conductivity, durability, and the like. The thickness of the cathode layer 34 is typically 10 nm to 10 µm, preferably 20 nm to 1 µm, more preferably 50 nm to 500 nm.

The cathode layer 34 can be formed in the same way as the anode layer 30. In the case of forming the cathode layer 34 by a vacuum deposition method, the cathode layer 34 can be formed by an electron beam vacuum deposition method with the use of the vapor deposition source 14 described in the first embodiment, for example. In the case where the cathode layer 34 has a multilayer structure, the same applies in the case of forming at least one of the film formation layers by a vacuum deposition method.

The organic EL device 26 may include a sealing member that seals the organic EL unit 32. The sealing member may be provided on the support substrate 28 so as to seal the organic EL unit 32 and partially expose the anode layer 30 and the cathode layer 34 for externally connecting the anode layer 30 and the cathode layer 34.

In the organic EL device 26, at least one of the anode layer 30 and the cathode layer 34 includes a film formation layer formed by an electron beam vacuum deposition method with the use of the vapor deposition source 14 described in the first embodiment. An example of a method for manufacturing the organic EL device 26 will be described. A method for manufacturing the organic EL device 26 while transporting a long support substrate 28 by a roll-to-roll method will be described herein.

First, the long support substrate 28 is prepared. While transporting the long support substrate 28 in the longitudinal direction, the anode layer 30 is formed discretely in the longitudinal direction of the support substrate 28 (anode layer forming step). Next, the organic EL unit 32 is formed on each anode layer 30 while transporting the support substrate 28 in the longitudinal direction (organic EL unit forming step). In the case where the organic EL unit 32 has a multilayer structure, multiple layers constituting the organic EL unit 32 may be formed in order from the side of the anode layer 30. Thereafter, the cathode layer 34 is formed on the organic EL unit 32 (cathode layer forming step). In the cathode layer forming step, as described previously, the cathode layer 34 is formed such that the cathode layer 34 is partially brought into contact with the support substrate 28.

The organic EL device 26 is formed for each anode layer 30 on the support substrate 28 subjected to the cathode layer forming step. Thus, the method for manufacturing the organic EL device 26 may include a singulation step of singulating the support substrate 28 subjected to the cathode layer forming step for each anode layer 30 to obtain product-size organic EL devices 26. In a mode in which the organic EL device 26 includes a sealing member, the organic EL unit 32 corresponding to each anode layer 30 may be sealed with a sealing member after the cathode layer forming step.

At least one of the anode layer forming step and cathode layer forming step of the method for manufacturing the organic EL device 26 includes a film formation layer forming step of forming the film formation layer 4 by an electron beam vacuum deposition method with the use of the vapor deposition source 14 described in the first embodiment. In this film formation layer forming step, the film formation layer 4 may be formed, with the substrate (film formation target substrate) 2 replaced by the support substrate 28 subjected to the steps before the film formation layer forming step in the method of forming the film formation layer 4 described with reference to Fig. 1.

For example, in the case of forming the cathode layer 34 in the film formation layer forming step, the substrate 2 shown in Fig. 1 may be replaced by the support substrate 28 with the organic EL unit 32 formed through the organic EL unit forming step, and the cathode layer 34 as the film formation layer 4 may be formed in the same way as in the method described in the first embodiment with the use of the material of the cathode layer 34 as the vapor deposition material 6. In the case where the cathode layer 34 has a multilayer structure, at least one of the layers may be the film formation layer 4. The same applies to the anode layer 30.

In the film formation layer forming step, the film formation layer 4 is formed by the electron beam vacuum deposition method with the use of the vapor deposition source 14 described in the first embodiment, and the film formation layer 4 can be thus continuously formed at high speed. Accordingly, the film formation layer 4 can be formed while continuously transporting the support substrate 28, thereby reducing the time for the film formation layer forming step of the organic EL device manufacturing method. As a result, the productivity of the organic EL device 26 is improved. Furthermore, the vacuum deposition apparatus 10 including the vapor deposition source 14 for use in the manufacture of the organic EL device 26 can be kept from being damaged. Furthermore, the vapor deposition material 6 is kept from being deposited on the wall surface in the vacuum deposition chamber 12, and thus maintenance of the vacuum deposition chamber 12 is easy.

The present invention is not to be considered limited to the various embodiments illustrated, but intended to encompass the scope specified by the claims, and encompass all modifications within the meaning and scope equivalent to the claims.

The crucible is not limited to the hearth liner, but may be any container that is capable of containing a vapor deposition material for electron beam vacuum deposition.

The surface of the heater on the edge side of the crucible has only to at least partially have a flat surface. There is no need for the first heating unit to serve as a planar heating element. For the first heating unit, for example, a wire or the like may be wound around a support member may generate heat. The support member is not limited to a planar (or plate-shaped) member, and may have a rod shape. Although the modification example of the first heating unit has been described, the same modification can be also applied to the second heating unit and the third heating unit.

The embodiment has been described in which the heater includes the second heating unit and the like which are separate from the first heating unit. The configuration of the heater is, however, not limited as long as a part of the heater surrounds the opening edge of the crucible. For example, the heater may have a configuration in which the first heating unit, second heating unit, and third heating unit are integrated.

The support substrate for use in the method for manufacturing an organic EL device does not have to be a long support substrate, and may be a single support substrate.

Although the anode layer is illustrated as the first electrode layer and the cathode layer is illustrated as the second electrode layer, the first electrode layer may serve as a cathode layer and the second electrode layer may serve as an anode layer. More specifically, the cathode layer may be disposed on the side with the support substrate (flexible substrate).

Although the method for manufacturing the organic EL device as an example of the electronic device has been described in the embodiments mentioned above, the present invention can be also applied to methods for manufacturing organic electronic devices such as an organic thin film transistor, an organic photodetector, an organic sensor, and an organic thin-film solar cell, besides the organic EL device. The present invention can be also applied to electronic devices (electronic devices other than organic electronic devices) in which functional layers of device function units are all made of inorganic materials.

### DESCRIPTION OF REFERENCE SIGNS

4...Film formation layer
6...Vapor deposition material
10...Vacuum deposition apparatus (electron beam vacuum deposition apparatus)
14...Vapor deposition source
20...Hearth liner (crucible)
20b...Edge
20d...Outer surface
22...Heater
24...Reflector
26...Organic EL device (electronic device)
28...Support substrate
30...Anode layer (first electrode layer)
32...Organic EL unit (device function unit)
34...Cathode layer (second electrode layer)
221...First heating unit (first heating region)
221a...Edge
222...Second heating unit (second heating region)
223...Third heating unit
C...Axis

## Claims

1. A vapor deposition source comprising:
a crucible that contains a vapor deposition material to be heated and evaporated by irradiation with an electron beam; and
a heater disposed to surround an edge of the crucible closer to an opening of the crucible.

2. The vapor deposition source according to claim 1, wherein a surface of the heater closer to the edge at least partially has a flat surface.

3. The vapor deposition source according to claim 1 or 2, wherein
the heater also surrounds an outer surface of the crucible, and
the heater is separated from the edge and the outer surface such that the vapor deposition material scattered from the crucible toward the heater is scattered toward the opening as viewed from a bottom of the crucible in an axial direction of the crucible.

4. The vapor deposition source according to claim 3, wherein
the heater has a first heating region located lateral to the edge, and a second heating region located closer to the bottom in the axial direction of the crucible than the first heating region,
the first heating region is disposed such that a distance between one region of the first heating region closer to the second heating region and the axis of the crucible is equal to a distance between the other region of the first heating region and the axis of the crucible, or shorter than the distance between the other region of the first heating region and the axis of the crucible, and
the second heating region is disposed such that a distance between one region of the second heating region closer to the first heating region and the outer surface of the crucible is equal to a distance between the other region of the second heating region and the outer surface of the crucible, or longer than the distance between the other region of the second heating region and the outer surface of the crucible.

5. The vapor deposition source according to any one of claims 1 to 4, wherein the edge of the heater farthest from the bottom of the crucible in the axial direction of the crucible is located farther from the bottom than the edge of the crucible in the axial direction of the crucible.

6. The vapor deposition source according to any one of claims 1 to 5, wherein the vapor deposition material is aluminum.

7. The vapor deposition source according to any one of claims 1 to 6, wherein the material of the crucible includes at least one of a pyrolytic boron nitride, a pyrolytic graphite, a pyrolytic silicon carbide, a pyrolytic silicon nitride, a pyrolytic aluminum nitride, an aluminum oxide, a boron nitride, an aluminum nitride, a silicon carbide, and a graphite.

8. An electron beam vacuum deposition apparatus comprising the vapor deposition source according to any one of claims 1 to 7.

9. A method for manufacturing an electronic device manufactured by sequentially forming a first electrode layer, a device function unit, and a second electrode layer on a support substrate,
wherein at least one of a step of forming the first electrode layer and a step of forming the second electrode layer includes a film formation layer forming step of forming a film formation layer by a vacuum deposition method with use of the vapor deposition source according to any one of claims 1 to 7.

10. The method for manufacturing an electronic device according to claim 9, wherein
the support substrate is long and flexible, and
in the film formation layer forming step, the film formation layer is formed while continuously transporting the support substrate.
